# EUROPEAN PATENT SPECIFICATION

(11) **EP 2 115 785 B1**
(45) Date of publication and mention of the grant of the patent: **16.06.2010**
(21) Application number: 08713395.5
(22) Date of filing: 04.02.2008
(51) Int. Cl.: H01L 31/048, H01L 31/052

(54) **SOLAR ELECTRIC MODULE**
SOLARSTROMMODUL
MODULE SOLAIRE

(30) Priority: 06.02.2007 US 888337 P
(43) Date of publication of application: 11.11.2009
(73) Proprietor: American Solar Technologies, Inc., North Chelmsford, MA 01863 (US)
(72) Inventor: KALEJS, Juris, P., Wellesley, MA 02481 (US)
(74) Representative: Lloyd, Patrick Alexander Desmond
(86) International application number: PCT/US2008/001465
(87) International publication number: WO 2008/097517

(56) References cited:
- EP-A- 1 020 930
- EP-A- 1 043 779
- WO-A-95/15582
- WO-A-2004/038462
- US-B1- 6 660 930

## Description

### Background

Photovoltaic cells have been long used as means of receiving solar energy and converting the solar energy into electrical energy. Such photovoltaic cells or solar cells are thin semiconductor wavers based on an EFG (edge-defined film-fed growth) substrate, which can be a polycrystalline silicon material. The solar cells can be various sizes and shapes. Several solar cells can be connected in series into a string by using electrical conductors. The strings of solar cells are arranged in a geometric pattern, such as in rows and columns, in a solar module and are interconnected electrically to provide an electric power output from the module.

A light reflector approach is used when the solar cells are spaced apart and a light reflecting material is placed in the spaces between the solar cells. Light is reflected upward from the light reflecting material, internally within the module, and some or all of the light may reach the front surface of a solar cell, where the solar cell can utilize the reflected light. U.S. Patent 4,235,643 to Amick describes such an approach for solar cells that are typically circular or hexagonal in shape. The solar module includes a support structure which is formed from an electrically nonconductive material such as a high density, high strength plastic. Generally, support structures are rectangular in shape. Dimensions for a support structure are, in one example, 46 inches long by 15 inches wide by 2 inches deep. Arrayed on the top surface of the support structure are solar cells connected in series by means of flexible electrical interconnections. Thus, the electrode on the bottom of one solar cell is connected via a flexible end connector to the top bus bar of the next succeeding solar cell. The bus bars connect electrically conductive fingers on the front (top) surface of the cell. The support structure has circular wells on the surface for receiving circular solar cells, and the solar cells are interconnected in the desired fashion. The land areas (that is, the area between the individual solar cells) are provided with facets with light reflective surfaces for reflecting light which normally impinges on the land area at an angle such that the reflected radiation, when it reaches the front surface of the optical medium covering the solar cell array, is internally reflected back down to the front surface of the solar cell array. The array mounted on the support structure must be coupled with an optically transparent cover material. There should be no air spaces between the solar cells and the optical medium or between the land areas and the optical medium. Typically, the optically transparent cover material is placed directly onto the front surface of the solar cells. The optically transparent cover has an index of refraction generally between about 1.3 to about 3.0 and is in the range of about 1/8 inch up to about 3/8 inch thick.

In one design of conventional solar cell modules using a light reflector approach, the solar cells are rectangular or square in shape, spaced apart, and arranged in rows and columns. The solar cells are encapsulated or "packaged", that is, bounded by physical barriers both on their front (top) and back (bottom) sides. Encapsulation helps protects the solar cells from environmental degradation, such as from physical penetration, and lessens degradation of the solar cells from the ultraviolet (UV) portion of the sun's radiation. Typically, the front barrier is a sheet of glass. The glass is bonded to a thermoplastic or thermosetting polymer encapsulant. This transparent or transmitting polymeric encapsulant is bonded to the front and back support sheets using a suitable heat or light treatment. The back support sheet may be in the form of a glass plate or a flexible polymeric sheet.

### Summary of the Invention

Documents WO 2004/038462 and EP-A-1043779 describe solar modules suitable for use with the ones of the present invention.

The invention is defined by the independent claims to which reference should be made.

In one embodiment, the back cover may have a surface nearest the transparent front cover that is reflecting at least over a portion of the surface exposed between the solar cells. The back cover may have a plurality of perforations of a predetermined size at least in regions obscured by the solar cells. Light is transmitted through the transparent front cover and is incident on the back cover in regions between the solar cells. The light is reflected towards the transparent front cover and internally reflected back from the transparent front cover towards the solar cells and back cover. The perforations enable migration of moisture into or out from the light transmitting encapsulant and the solar cells.

In one aspect, the back cover is a composite backskin, and a surface of the composite backskin nearest to the transparent front cover has a reflective coating. The reflective coating is absent from the surface of the back cover in at least portions of regions obscured by the solar cells. The back cover includes a composite backskin and a reflecting layer disposed on a surface of the composite backskin nearest to the solar cells. The composite backskin and the reflecting layer are fabricated from a single sheet.

Preferably, the back cover includes a backskin layer having a front surface facing the transparent front cover. The backskin layer may have a permeability index from about one to about ten grams per square meter per day. The backskin layer may include a polyvinyl fluoride polymer. The backskin layer and the reflecting layer may be fabricated from a single sheet to form a composite backskin. The reflecting layer may include a support layer and a reflective coating disposed on a surface of the support layer facing away from the transparent front cover. The light transmitting encapsulant may include ethyl vinyl acetate. The perforations may form a plurality of windows. Each window of the plurality of windows may be adjacent to each back surface of each solar cell. In another aspect, the reflecting layer is a reflective metal.

In one preferred embodiment, the first layer of transparent material is a thermosetting plastic. The thermosetting plastic, may comprise ethyl vinyl acetate. The weight mitigation layer may include ethyl vinyl acetate and an ionomer. The weight mitigation layer may include one or more sheets of ionomer disposed between two sheets of ethyl vinyl acetate. The transparent front cover may be a glass sheet having a thickness of approximately one millimetre to about ten millimetres, and the weight mitigation layer may have a thickness of approximately about one millimetre to about ten millimetres. In a further embodiment the transparent front cover may be a glass sheet having a thickness of approximately three millimetres to approximately six millimetres, and the weight mitigation layer may have a thickness of approximately two millimetres to approximately six millimetres. The weight mitigation layer may include two sheets of ionomer and two sheets of ethyl vinyl acetate. Each sheet of ionomer may have a thickness of about one millimetre. Each sheet of ethyl vinyl acetate may have a thickness of about one-half millimetre. The two sheets of ionomer may be bonded between the two sheets of ethyl vinyl acetate. In another preferred embodiment, the weight mitigation layer may include six sheets of ethyl vinyl acetate, each sheet of ethyl vinyl acetate having a thickness of about one half millimetre. The transparent front cover may comprise a glass sheet having a thickness of approximately five millimetres, and the weight mitigation layer may have a thickness of approximately two millimetres. In a further embodiment, the weight mitigation layer may include a sheet of ionomer having a thickness of about one millimeter, and two sheets of ethyl vinyl acetate each having a thickness of about one-half millimeter. The sheet of inonomer may be bonded between the two sheets of ethyl vinyl acetate.

In one aspect, the invention features a solar electric module including: a transparent front cover, a plurality of solar cells, a back cover, a light transmitting encapsulant, means for reflecting, and means for moisture control. The transparent front cover has a front surface and a back surface. The solar cells are configured in a substantially coplanar arrangement and spaced apart from each other. The back cover is spaced apart from and substantially parallel to the transparent front cover. The solar cells is disposed between the transparent front cover and the back cover. The solar cells have front surfaces facing the transparent front cover and back surfaces facing away from the transparent front cover. Each solar cell has one front surface and one back surface. The light transmitting encapsulant is disposed between the transparent front cover and the back cover. The reflecting means is disposed between the solar cells and the back cover. The reflecting means is disposed between the solar cells and the back cover. The transparent front cover transmits light through the transparent front cover, and the light is incident on the reflecting means in regions between the solar cells. The reflecting means directs the light towards the transparent front cover. The front surface of the transparent front cover internally reflects the light back towards the front surfaces of the solar cells. The moisture control means including a plurality of perforations of a predetermined size formed in the reflecting means at least in regions obscured by the solar cells. The perforations provide moisture transport into and out from the light transmitting encapsulant.

In one aspect, the invention features a solar electric module including a transparent front cover, a plurality of solar cells, a back cover, a light transmitting encapsulant, a reflecting layer, and a means for weight mitigation. The transparent front cover has a front surface and a back surface. The solar cells are configured in a substantially coplanar arrangement and spaced apart from each other. The back cover is spaced apart from and substantially parallel to the transparent front cover. The solar cells are disposed between the transparent front cover and the back cover. The solar cells have front surfaces facing the transparent front cover and back surfaces facing away from the transparent front cover. Each solar cell has one front surface and one back surface. A light transmitting layer is disposed between the transparent front cover and the back cover and encapsulates the solar cells. The light transmitting layer includes a first layer of transparent material and a second layer of transparent material. The first layer is disposed adjacent to the back surface of the transparent front cover. The second layer is disposed adjacent to the back surfaces of the solar cells. The reflecting layer is disposed between the solar cells and the back cover. The transparent front cover transmits light through the transparent front cover and incident on the reflecting layer in regions between the solar cells. The reflecting layer directs the light towards the transparent front cover, and the front surface of the transparent front cover internally reflects the light back towards the front surfaces of the solar cells. The first layer of transparent material includes one or more encapsulating sheets adjacent to the front surfaces of the solar cells. The means for weight mitigation is disposed between the back surface of the transparent front cover and one or more encapsulating sheet. The weight mitigation means has a density less than the transparent front cover, and replaces a volume of the transparent front cover equal to a volume of the weight mitigation layer.

### Brief Description of the Drawings

The above and further advantages of this invention may be better understood by referring to the following description in conjunction with the accompanying drawings, in which like numerals indicate like structural elements and features in various figures. The drawings are not necessarily to scale, emphasis instead being placed upon illustrating the principles of the invention.
FIG. 1 is a fragmentary diagrammatic side elevation illustrated solar cells arrayed on a support structure.
FIG. 2 is an exploded schematic representation of a cross section of a solar cell module including a weight mitigation layer in accordance with the principles of the invention.
FIG. 3 is a schematic representation of a cross section of a laminated solar cell module illustrating light reflection in accordance with the principles of the invention.
FIG. 4 is an exploded schematic representation of components of a solar cell module including a weight mitigation layer in accordance with the principles of the invention.
FIG. 5 is a schematic representation of a cross section of a laminated solar cell module including a weight mitigation layer in accordance with the principles of the invention.
FIG. 6 is a schematic representation of a cross section of components of a first transparent layer according to the principles of the invention.
FIG. 7 is an exploded schematic representation of a cross section of a solar cell module including a composite backskin in accordance with the principles of the invention.
FIG. 8 is a plan (overhead) view of a solar cell module including moisture permeability areas, according to the principles of the invention.
FIG. 9 is a schematic representation of a cross section of a laminated solar cell module including a moisture mitigation feature in accordance with the principles of the invention.

### Detailed Description

This invention relates to the structure and manufacture of solar electric modules which include interconnected solar cells disposed between a front (top) protective support sheet or superstrate (which may be a flexible plastic sheet or a glass plate) transparent to most of the spectrum of the sun's radiation, and a back (bottom) support sheet or substrate. Elements and techniques for module construction are described which enable simpler manufacturing procedures and raise market acceptance of modules for large commercial flat roof installations, where the total weight of the modules may be excessive. These elements and techniques can be combined with concentrating light principles in module designs which use reflector materials to reduce module costs by reducing the number of solar cells used to as few as one-half to one-third of those used in conventional modules without a light reflector feature. In one aspect, the invention features a method to reduce the weight of a module while retaining cost benefits arising from a light reflecting material, thus increasing the market penetration window for the "low concentrator" general class of light reflector solar products. In another aspect, the invention features a method to simplify construction and manufacture of a module by combining at the back of the module the light reflection and cost reducing element with a conventional barrier sheet, which is termed the module "backskin." In another aspect, the invention provides moisture control features, such as, in one embodiment, a backskin having a controlled moisture ingress to and egress from the module interior.

The approach of the invention simplifies module design and manufacture, and broadens the market for solar electric modules. Cost reductions are realized by enabling the total number of cells in a module to be reduced while maintaining module performance (that is, maintaining a similar level of output of electrical power as modules without the approach of the invention).

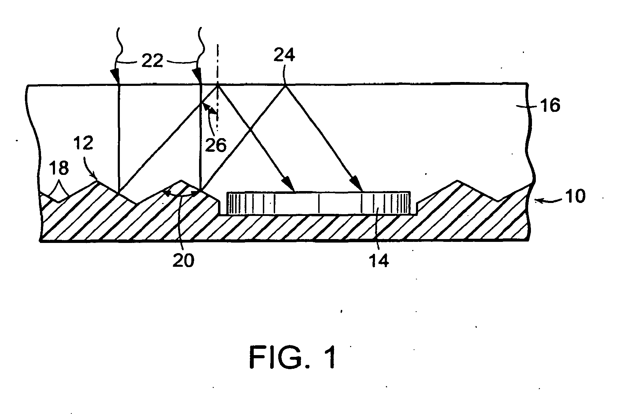

FIG. 1 is a fragmentary diagrammatic side elevation illustrated solar cells arrayed on a support structure. FIG. 1 illustrates one conventional approach for a light reflector module based on U.S. Patent 4,235, 643 to Amick. The approach shown in FIG. 1 is suitable for use with the approach of the invention, but is not limiting of the invention. Solar cells 14 are arrayed and mounted on a support structure 10 and then covered by and coupled with an optically transparent layer 16. The optically transparent cover material 16, as shown in the conventional approach of FIG. 1, for example, is any one of the silicone rubber encapsulating materials generally known to the electronics and solar cell industry or other ultra-violet stable and weather resistant materials.

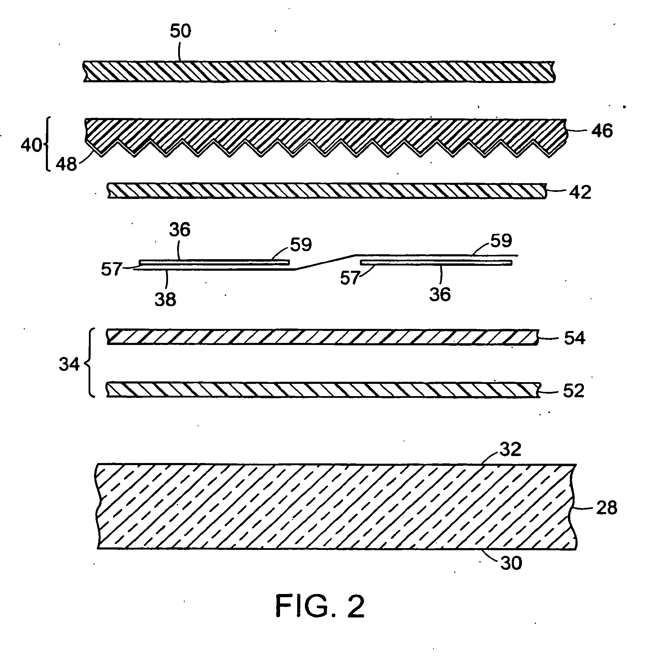

FIG. 1 is suitable for use with the approach of the invention in accomplishing a weight control or mitigation goal by replacing the optically transparent layer with a relatively thin sheet of glass forming a top layer, and an optically transparent plastic layer between the thin top sheet of glass and the solar cells 14. This approach of the invention combines the advantage of a hard, scratch resistance, protective cover of glass with the use of lighter weight, typically plastic, materials, as is discussed in more detail elsewhere herein (see FIGS. 2 through 6 illustrating the weight mitigation approach of the invention).

In the conventional approach of FIG. 1, the land areas 12 between the solar cells 14 arrayed on the surface of the support structure 10 have facets having light reflective surfaces 18. The light reflective surfaces 18 may be mirrored surfaces, polished metal and the like.

As is shown in the conventional approach of FIG. 1, the facets are in the form of V-shaped grooves having the light reflective surfaces 18. The depths of the grooves are generally in the range of about 0.001 inch to about 0.025 inch or approximately 0.1 of the thickness of the optically transparent cover material 16. The angle 20 at the vertex formed by two upwardly sloping planes of the facets or grooves must be in the range of about 110 degrees to 130 degrees and preferably at an angle of 120 degrees. Also, in one embodiment, the depth of the groove is about 0.3 millimeters.

As is shown in FIG. 1, the faceted region 12 is substantially coplanar with solar cells 14. In one embodiment, the vertical height of the facet will be equal to the thickness of a solar cell 14 and the facets will be arranged so that the facet will not extend below the bottom surface of the cell 14.

As can be seen in FIG. 1, normal vertically incident solar radiation designated, for example, generally by reference numeral 22, which impinges on normally inactive land areas 12 is reflected by the reflecting surfaces 18 of the facets provided in the land area 12 so that the radiation re-enters the optical medium 16. When the reflected radiation reaches the front surface 24 of the optical medium, and if it makes an angle 26 greater than the critical angle, the radiation will be totally trapped and reflected down to the back surface. The critical angle refers to the largest value which the angle of incidence 26 may have for a ray of light 22 passing from a more dense medium to a less dense medium. If the angle of incidence 26 exceeds the critical angle, the ray of light 22 does not enter the less dense medium but will be totally internally reflected back into the denser medium (the optical medium 16).

The solar radiation 22 on arrival can strike a solar cell 14 rather than the land region 12, in which event it will be absorbed and contribute to the electric output of the module. This ability to redirect light striking inactive surfaces so that it will fall on active surfaces permits arraying of the cells 14 at greater distances with minimum loss in output per unit area, hence raising the output power and/or lowering the cost per watt for a solar cell module.

Significantly, the geometry of the facets should be such that light reflected from surfaces 18 of the facets in land area 12 is not shadowed or blocked by an adjacent facet. Additionally, light upon being reflected from surfaces 18 and land area 12 when it reaches the front surface 24 of the optical medium 16 must make an angle 26 exceeding the critical angle with the front surface 24.

As indicated, the surfaces 18 of the grooves on land area 12 can be smooth optically reflecting surfaces; that is, they should have a solar absorptance less than 0.15. These surfaces can be prepared by coating machined or molded grooves with a suitable metal such as aluminum or silver, for example.

By way of example but not limitation on the approach of the invention, solar cell modules may take the form described and illustrated in U.S. Patent Nos. 5,478,402 to Hanoka, 6,586,271 to Hanoka and 6,660,930 to Gonsiorawski. Generally, these patents (5,478,402; 6,586,271; and 6,660,930) describe solar cell modules composed of layered constructs typically including a transparent front cover, a plastic (encapsulating) layer, solar cells 14, a plastic (encapsulating) layer, and a back cover. The solar cells 14 are typically connected by electrical conductors that provide electrical connections from the bottom surface of one solar cell 14 to the top surface of the next adjacent solar cell 14. The solar cells are connected in series into a string of solar cells 14.

In some conventional approaches, a reflecting layer is included behind the array of solar cells 14. Such a reflecting layer has been proposed in various embodiments of module construction. By way of example but not limitation on the approach of the invention, solar cell modules may take the form described in U.S. patent No. 5,994,641 to Kardauskas (hereinafter "Kardauskas"), which is also known as a "low concentrator" module design. Generally, Kardauskas describes a solar cell module having a transparent front cover, a plastic layer, solar cells 14, a reflecting layer, a plastic layer, and a back cover.

FIG. 2 is an exploded schematic representation of a cross section of a solar cell module including a weight mitigation layer 52 in accordance with the principles of the invention.

The disclosed module construction shown in Fig. 2 includes a transparent front panel (for example, front sheet of glass) 28, a first layer of encapsulant 34, which is placed in front of the solar cells designated generally by the reference numeral 36 and in which the solar cells 36 are embedded, a second (back) layer of encapsulant 42, a reflecting layer 40, and a sheet of "back" glass 50. The reflecting layer 40 includes a reflecting layer support 46, which is preferably a polymer sheet coated with a thin metal layer 48. The reflector layer support 46 is bonded to the back glass 50.

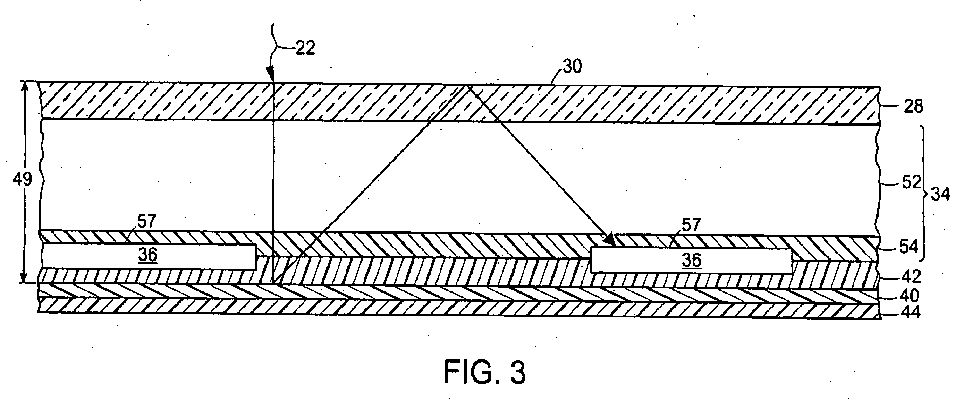

The transparent front panel 28 has a front surface 30 and back surface 32. The transparent front panel 28 is composed of one or more transparent materials that allow the transmission of solar light rays 22 (shown in FIG. 3). In one embodiment, the transparent front panel 28 is glass, having a density of about 2 to 4 grams per cubic centimeter. In other embodiments, the transparent front panel 28 is composed of a transparent polymer material, such as an acrylic material.

The solar cells 36 have a front surface 57 and a back surface 59. The solar cells 36 are connected by conductors designated generally by the reference numeral 38 (also referred to as "tabbing').

The reflecting layer 40 with reflective coating 48 provides a reflecting layer for one embodiment of the invention. The reflective coating 48 is a metallic material, for example aluminum. In another embodiment, the reflective coating 48 is silver, which is more reflective than aluminum but is typically also more expensive. In one embodiment, the reflective coating 48 is coated or overlaid with a transparent electrically insulating layer to prevent electrical current from flowing between the reflective coating 48 and any conductors 38 or electrical contacts associated with the back surfaces 59 of the solar cells 36, or other electric circuitry associated with the module In preferred embodiment the reflective coating or layer 48 is located on a surface of the support 46 that is facing the backskin 44 or back panel 50. The support 46 is transparent to light so that light rays 22 can pass through the support, are incident on the reflecting coating or layer 48, and reflected back through the support 46 toward the transparent front panel 28.

By way of example but not limitation on the approach of the invention, the approach of the invention is also suitable for use with a grooved reflective support layer 46 according to the approach of Amick. The depths of the grooves are generally in the range of about 0.001" to 0.025" or approximately 0.1 of the thickness of the optically transparent cover material. The angle 20 (see FIG. 1) at the vertex formed by two upwardly sloping planes of the facets or grooves must be in the range of about 110 degrees to 130 degrees and preferably at an angle of 120 degrees.

By way of example but not limitation on the approach of the invention, the approach of the invention is suitable for use with a grooved reflective support layer 46 according to the approach of Kardauskas. One example provided in Kardauskas indicates that the support layer 46 has a thickness of about .004 inch to about .010 inch and V-shaped grooves. The grooves have an included angle between 110 degrees and 130 degrees (as in angle 20 in FIG. 1). In one embodiment, the grooves have a depth of above 0.002 inch, and a repeat (peak to peak) spacing of about 0.007 inch. The reflective coating 48 of aluminum or silver has a thickness in the range of about 300 angstroms to about 1000 angstroms, preferably in the range of 300 angstroms to about 500 angstroms. The facets, in one embodiment, are in the form of V-shaped grooves.

The first layer of encapsulant 34 includes one or more weight control sheets or layers designated generally by the reference numeral 52 and encapsulating sheet 54 (to be discussed in more detail elsewhere herein.

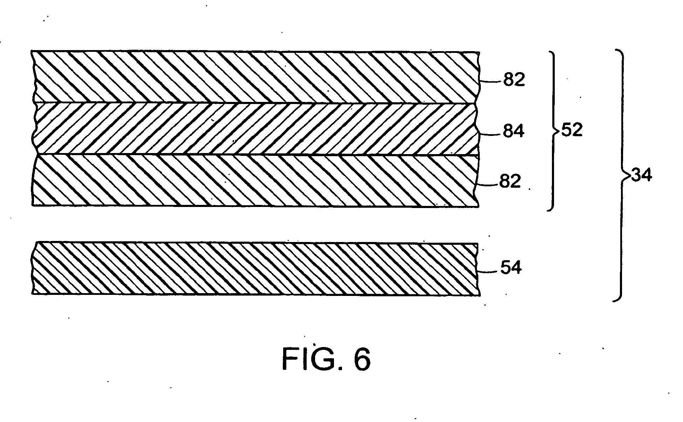

Generally, the encapsulating layers 34 and 42 include one or more plastic materials. In one embodiment, the layers 34 and 42 include ethyl vinyl acetate (EVA). The layers 34 and/or 42 can include other materials, such as UV blocking materials which aid in preventing degradation of the EVA, or the UV blocking materials can be included in the EVA. In another embodiment, the encapsulating layers 34 and 42 include an ionomer. In further embodiments, the encapsulating layer 34 includes both EVA and ionomer materials (see FIG. 6). In various embodiments, the encapsulating layers 34 and 42 are composed of a UV-resistant EVA material, such as 15420/UF or 15295/UF provided by STR (Specialized Technology Resources, Inc.) that resists degradation and yellowing.

In one aspect of the invention, a weight mitigation approach is featured. One related problem is the lack of availability of material used to construct solar cells. Efficient modules having reduced numbers of solar cells 36 have become increasingly desirable in recent years due to shortages of silicon raw material, or "feedstock." Silicon solar cell based products comprise over 85% of the current solar electric products sold worldwide in 2006.

One aspect of the invention features a solar electric module (see FIG. 2) having a reduced weight compared to existing solar electric modules. The reduced-weight module with fewer numbers of silicon solar cells 36 is advantageous for large-area flat roof installations. The amount of silicon feedstock required for each watt of module power and kWh of energy produced over the module lifetime is reduced. In many implementations of flat roof arrays of solar cells 36, the arrays include between 3000 and 5000 solar electric modules. Each module typically weighs approximately 50 lbs. Typically, the modules are installed on warehouses with large roof areas. Racks of modules are sufficiently heavy that typically they are hoisted to the roof with tall cranes for installation. Installed weight is a critical factor in flat roof array applications. The problem of excessive installed weight (for example, more than five pounds per square foot) prevents acceptance of module products if the weight is more than the acceptable threshold. Module weight often comprises 50 to 75% of the installed array roof load. It is often desirable to reduce the installed weight to the five pounds per square foot threshold or lower. Total roof loads for large module arrays without any weight reduction or mitigation features typically range from 50 to 100 tons.

For example, a front cover glass sheet of 3 mm thickness allows solar cells 36 to be spaced by greater distances than solar cells 36 in prior (conventional) solar electric modules, resulting in a reduction of the number of solar cells 36 by one third while maintaining parity to within about 10 percent to about 15 percent in module power density for a given area. The cell spacing can be further increased and the number of solar cells 36 can further be reduced by an additional about 30 percent to about 50 percent if the thickness of the front glass cover sheet 28 is doubled to 6 millimeter from 3 millimeter. The reduction in solar cells 36 is approximately one-half to one-third of the cells 36 (compared to the number of solar cells 36 used in a conventional module without the reflecting layer 40). Doubling the glass thickness (for example to 6 mm) can increase the installed weight density to seven to eight pounds per square foot. The increased weight can make the module unsuitable for a large number of flat roof installations despite the reduced number of solar cells 36.

According to embodiments of the invention, one or more extra sheets 52 of transparent material (that is, the encapsulant) are inserted between an encapsulating layer 54 of typical thickness (that is, in a range of about one-half millimeter to about one millimeter) and the front cover glass 28 The extra weight mitigation sheets 52 increase the separation between the solar cells 36 and the air-glass interface (the front surface 30 of the transparent front panel 28) at which total internal reflection occurs. Using additional encapsulant layers 52 instead of increasing glass thickness achieves the desired reduction in the number of solar cells 36 with less increase in weight than would otherwise occur for the increased glass thickness. In various embodiments, the extra sheets of weight mitigation material 52 can be thermosetting plastic ethyl vinyl acetate (EVA), ionomer, or a combination of sheets of EVA and ionomer. In other embodiments, additional encapsulant layers 36 can be used in combination with an increased glass thickness. The weight mitigation material 52 has a density less than the density of a glass transparent front panel 28, which in one embodiment has a density in a range of about 2 grams per cubic centimeter to about 4 grams per cubic centimeter.

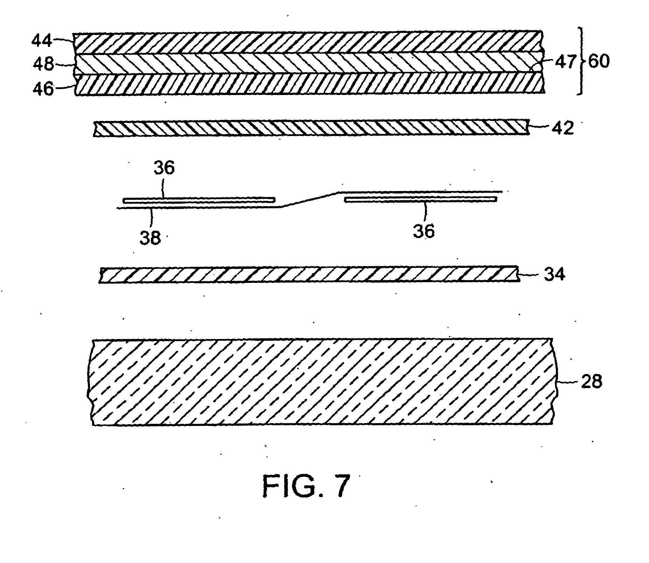

FIG. 3 is a schematic representation of a cross section of a laminated solar cell module illustrating a light reflection in accordance with the principles of the invention. The laminated solar cell module of FIG. 3 includes a transparent front panel 28, first light transmitting layer 34, solar cells 36, second light transmitting layer 42, reflecting layer 40 including reflective coating 48 (not shown), and backskin 44. The first light transmitting layer 34 includes weight mitigation layer 52 and encapsulating sheet 54. The weight mitigation layer 52, in one embodiment, includes multiple encapsulating sheets (not shown in FIG. 3, see FIG. 6). Incident light 22 is transmitted through the front transparent panel 28, is reflected upwards by the reflecting layer 40, reflected internally by the top surface 30 of the transparent front panel 28, and then impinges on the top surface 57 of a solar cell 36. The reflecting layer distance 49 (also termed light redirecting layer distance 49) is the distance between the reflecting layer 40 and the front surface 30 of the transparent front panel 28. The dimensions of the illustrated components 28, 52, 54, 36, 42, 40, and 44 are not necessarily to scale in FIG. 3. The reflecting layer 40 includes a reflective coating support 46 with a metallic coating 48. In other embodiments, the reflecting layer 40 is a metallic layer (for example, aluminum or silver). In another embodiment, the reflecting layer 40 is a composite backskin 60 (see FIG. 7).

In the approach of the invention, the goal is to increase the reflecting layer distance 49 without increasing the weight of the transparent front panel 28 (for example, when the transparent front panel 28 is glass). When the reflecting layer distance 49 is increased, the incident radiation 22 can be reflected a greater horizontal distance, because the incident radiation 22 is reflected upward at an angle and then reflected by the front surface 30 downward at an angle, which allows the solar cells 36 to be spaced farther apart with the increase in the reflecting layer distance 49 provided by the weight mitigation layers 52.

In one typical conventional approach, which is not meant to be limiting of the invention, the transparent front panel 28 is a glass sheet of about three millimeters in thickness, the encapsulating sheet 54 has a thickness of about 0.5 millimeters, (no weight mitigation sheet 52 is included), the solar cell 36 has a thickness of about 0.25 millimeters or less, the reflecting layer 46 is 0.25 millimeters (or less), the second or back encapsulating sheet 42 is about 0.25 millimeters, and the back cover is about 0.25 millimeter.

In the approach of the invention, the first layer of light transmitting material 34 includes both the encapsulating sheet 54 and one or more weight mitigation sheets 52. The one or more sheets of the weight mitigation layer 52 can form a layer as thick as 10 millimeters, in one embodiment, while the solar electric module retains a relatively thin thickness for the transparent front panel 28. The increased weight mitigation thickness increases the reflecting layer distance 49, which in turn, allows a greater spacing between the solar cells 36.

In one conventional approach, the solar electrical module includes a transparent front cover 28 of glass which is about 1/8 inch in thickness and the solar cells 36 are about 10 mm apart in spacing.

In the approach of the invention, the weight mitigation layer 52 is included, so that the transparent front cover 28 is about 1/8 inch or about 5/32 inch in thickness (or about 3 millimeters or less in thickness) and the spacing between solar cells can be increased to a range of about 15 to about 30 millimeters. In various embodiments, the width of the solar cells 36 are in the range of about 25 to about 75 millimeters. In one embodiment, the solar cells 36 have a thickness of about 0.25 millimeters (or less) and are rectangular in shape with the long dimension being about 125 millimeters, and the short dimension being about 62.5 millimeters. In various embodiments of the invention, the transparent front panel 28 ranges in thickness from one millimeter to ten millimeters in thickness. In preferred embodiments of the invention, the transparent front panel 28 ranges in thickness from about 1/8 inch to about 1/4 of an inch in thickness. In other preferred embodiments the transparent front panel 28 ranges in thickness from about 3 millimeters to about 6 millimeters in thickness.

In one preferred embodiment of the invention, the reflecting layer 40 provides a light recovery of about 20 to about 30 per cent. The transparent front cover 28 is about 3 millimeters in thickness, and the weight mitigation layer 52 is about 3 millimeters. The solar cells 36 have dimensions of about 62.5 millimeters by about 125 millimeters and a thickness of about 0.25 millimeters or less. The solar cells 36 have a spacing of about 15 millimeters apart.

In other embodiments, the solar cells 36 have the form of strips (also termed "ribbons") with a width of about 8 millimeters to about 25 millimeters and a length in the range of about 100 millimeters to about 250 millimeters.

In another embodiment, the strip solar cell 36 is about 25 millimeters wide by about 250 millimeters in length. The spacing between the strip solar cells 36 is about 5 millimeters to about 25 millimeters. The weight mitigation layer 52 has a thickness of about 3 millimeters to about 6 millimeters (and up to 10 millimeters). In one embodiment, the solar electric module has about 60 strip solar cells 36 of about 25 millimeters in width and 250 millimeters in length, each strip solar cell 36 producing about 0.6 volts, so that the open circuit voltage output of the solar electric module is 36 volts.

In various embodiments of the invention, the weight mitigation layer 52 ranges in thickness from about one-half millimeter to about 10 millimeters. In one embodiment, the transparent front panel 28 has a thickness of about 3 millimeters to about 6 millimeters and the weight mitigation layer 52 has a thickness of about 2 millimeters to about 6 millimeters. The weight mitigation layer 52, in another embodiment, includes six sheets of EVA, each sheet having a thickness of about one-half millimeter. In another embodiment, the transparent front panel 28 has a thickness of about 2 millimeters and the weight mitigation layer 52 has a thickness of about 5 millimeters.

The weight mitigation aspect of the invention retains the advantages of a glass cover 28 (for transparency, resistance to degradation, protection of the front of the module, moisture impermeability that does not transmit water, and hardness (scratch resistance)) while limiting the thickness (and weight) of the transparent front panel 28. The use of the weight mitigation layer 52 increases the reflecting layer distance 49, which, in turn allows the solar cells 36 to be space farther apart. As a result, a solar electric module can provide about the same power output with fewer solar cells 36 compared to a solar electric module without any weight mitigation layer 52.

Generally, the weight mitigation aspect of the invention also provides the unexpected result of increased reliability, because there are fewer solar cells 36. The weight mitigation approach of the invention also provides the unplanned and fruitful result of providing more U-V protection to components (for example, reflecting layer 40) below the weight mitigation layer 52, because the increased polymer layer (for example, EVA) typically has U-V blocking or absorbing properties.

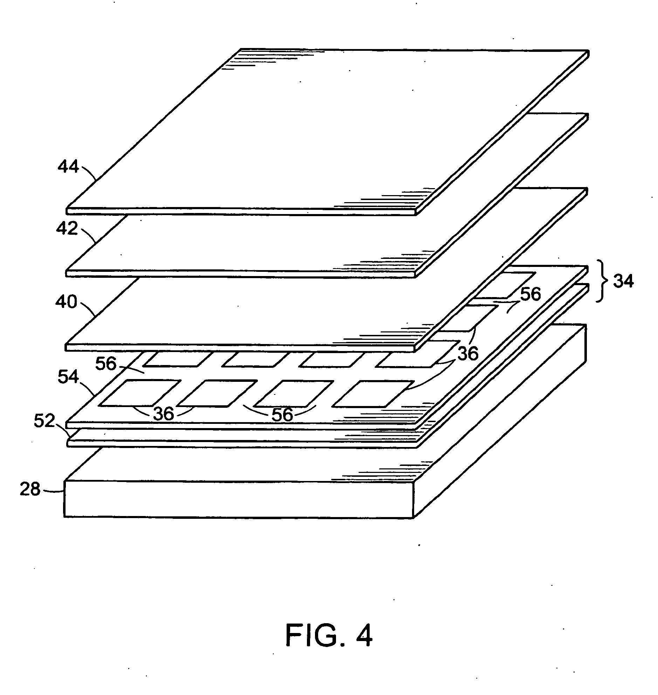

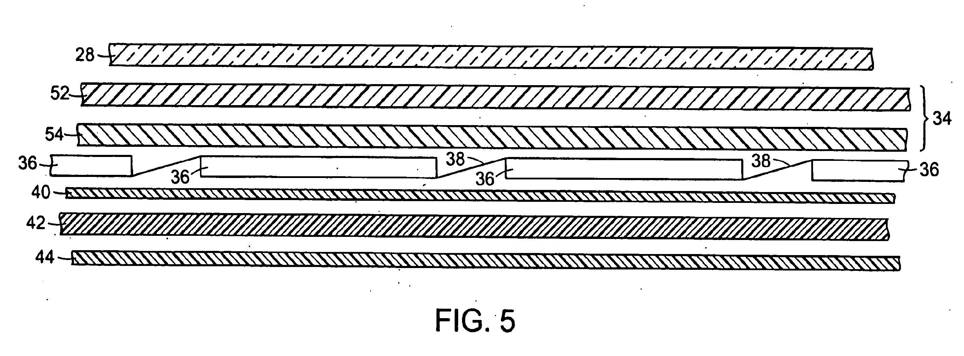

FIG. 4 is an exploded schematic representation of components of a solar cell module including a weight mitigation layer 52 in accordance with the principles of the invention. FIG. 5 is a schematic representation of a cross section of a laminated solar cell module including a weight mitigation layer 52 in accordance with the principles of the invention. The solar cell module illustrated in FIGS. 4 and 5 includes a superstrate or transparent front panel 28, a first layer of light transmitting material 34, an array of separately formed crystalline solar cells 36, regions between solar cells designated generally by reference numeral 56 (shown in FIG. 4), reflecting layer sheet 40, second layer of transparent encapsulant 42, and 44 backskin. The first layer 34 includes a weight mitigation layer 52 and an encapsulating sheet 54. FIG. 5 illustrates the conductors 38 (for example, tabbing) that electrically interconnect the solar cells 36. In one embodiment, the reflecting layer sheet 40 includes the grooved technology illustrated in FIG. 2 as reflective coating support 46 and reflective coating 48. In other embodiments, the reflecting layer 40 is based on other approaches without requiring the grooved approach shown for the reflective coating support 46 in FIG. 2. In another approach, the reflecting layer 40 includes a mirrored, polished metal, and/or patterned surface (having patterns other than grooves) that is reflective or is coated with a metallic reflective material 48. These reflective materials include aluminum, silver, or other reflective material. In one embodiment, the reflecting layer 40 is a white surface based on any suitable material, or other suitable reflecting layer or structure, as well as reflecting layers to be developed in the future. In one embodiment, the reflecting layer 40 is positioned between the second light transmitting layer 42, which is adjacent to the solar cells 36, and the backskin 44. Generally the approach of the invention does not require that the layers be provided in the order shown in FIG. 4 and FIG. 5.

The solar electric module of the invention can be fabricated using lamination techniques. In this approach, separate layers of the invention, 28, 34, 36, 40, 42, and 44 can be assembled in a layered or stacked manner as shown in FIGS. 4 and 5. The layers can then be subjected to heat and pressure in a laminating press or machine. The first light transmitting layer 34 and the second layer 42 are made of plastics (e.g., polymer, EVA, and/or ionomer) that soften or melt in the process, which aids in bonding all of the layers, 28, 34, 36, 40, 42, and 44 together.

By way of example but not limitation on the approach of the invention, the solar electric module of the invention can be fabricated using a lamination technique such as that disclosed in U.S. Patent No. 6,660,930 to Gonsiorawski. Referring to FIG. 4 and FIG. 5, components of a conventional form of solar cell module are modified to incorporate the present invention and its manufacturing steps are shown. The dimensions of the illustrated components are not necessarily to scale in FIG. 4 and FIG. 5.

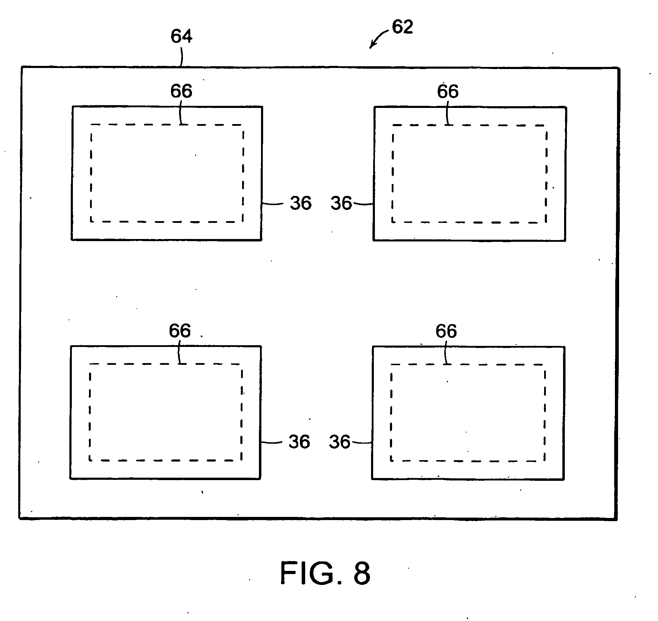

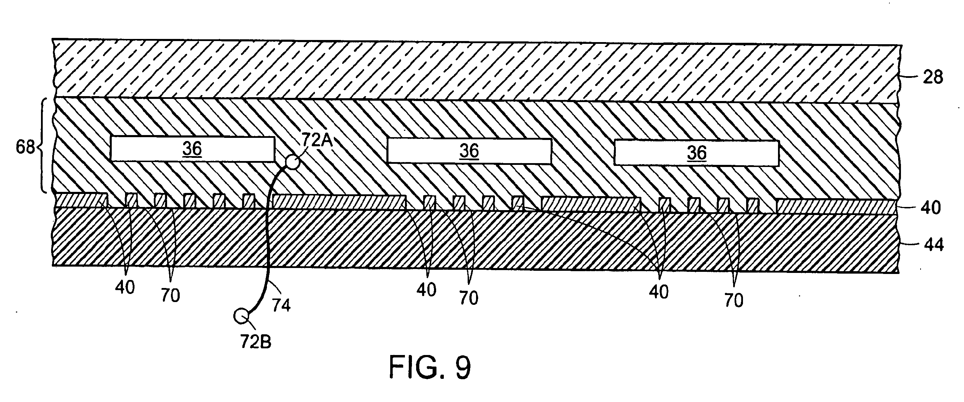

In the approach of the invention, reflecting layer sheet 40 is inserted separately as shown in FIG. 5 or it is formed as a composite 60 (see FIG. 7) with the backskin 44. The backskin can have perforations adjacent to the back side of the solar cells 36 in order to admit passage of a controlled amount of moisture according to one aspect of the invention (see FIGS. 8 and 9).

In this conventional manufacturing process, although not shown in FIG. 4 or FIG. 5, it is to be understood that some, and preferably all, of the individual conductors 38 that connect adjacent solar cells or strings of cells are oversize in length for stress relief and may form individual loops between the cells. Each cell has a first electrode or contact (not shown) on its front radiation-receiving surface 57 and a second electrode or contact (also not shown) on its back surface 59, with the conductors 38 being soldered to those contacts to establish the desired electrical circuit configuration.

In the approach of the invention, each of the layers 34 and 42 include one or more sheets of encapsulant material, depending upon the thickness in which the encapsulant is commercially available, or the thickness required to replace glass by encapsulant (as indicated by inclusion of a weight mitigation layer 52 as described for FIG. 2) in order to reduce module weight.

Although not shown, it is to be understood that the solar cells 36 are oriented so that their front contacts face the glass panel 28, and also the cells 36 are arranged in rows; that is, strings, with the several strings being connected by other conductors (not shown) similar to conductors 38 and with the whole array having terminal leads (not shown) that extend out through a side of the assembly of components. In one embodiment of the invention, electrically insulating film or materials are placed over the contacts on the solar cells 36 (before the assembly and lamination process) to prevent an electrical current flowing between the contacts and the reflecting layer 40, or other parts of the module

The foregoing components 28, 34, 36, 40, 42, 44, are assembled during manufacturing in a laminate configuration starting with the glass panel 28 on the bottom. After the laminate is assembled into a sandwich or layered construct of components 28, 34, 36, 40, 42, and 44, the assembly is transferred to a laminating apparatus (not shown) where the components 28, 34, 36, 40, 42, and 44 are subjected to the laminating process. The laminating apparatus is essentially a vacuum press having heating means and a flexible wall or bladder member that contacts with a wall member or platen to compress the components 28, 34, 36, 40, 42, and 44 together when the press is closed and evacuated. The sandwich, or layered construct of components 28, 34, 36, 40, 42, and 44 shown in FIGS. 4 and 5, is positioned within the press and then the closed press is operated so as to heat the sandwich (or layered construct) in vacuum to a selected temperature at which the encapsulant melts enough to flow around the cells 36, usually at a temperature of at least 120 degrees C, with the pressure applied to the components 28, 34, 36, 40, 42, and 44 increasing at a selected or predetermined rate to a maximum level, usually about one atmosphere. In various embodiments, the temperature is as high as 150 degrees C. These temperature and pressure conditions are maintained long enough, typically for about 3 to 10 minutes, to allow the encapsulant of layer 54 to fill in all spaces around the cells 36 and fully encapsulate the interconnected cells 36 and fully contact the front and back panels 28 and 44, after which the pressure is maintained at or near the foregoing minimum level while the assembly (the layered construct) is allowed to cool to about 80°C or less so as to cause the encapsulant of layers 34 and 42 to form a solid bond with the adjacent components 28, 36, 38,40, and 44 of the module. The pressure exerted on the sandwich (layered construct) of module components 28, 34, 36, 38, 40, 42, 44 reaches its maximum level only after the assembled components 28, 34, 36, 38, 40, 42, 44 have reached the desired maximum temperature in order to allow the encapsulant of layers 34, 42 to reform as required and also to assure full removal of air and moisture. The module is completed by attaching to the laminate sandwich (that is, laminated layered construct) a junction box with wiring to external connectors and a frame (for example, a rectangular frame that surrounds and holds a rectangular laminated layered construct and that connects to a rack that supports multiple modules).

The manufacturing process, as described for FIG. 4 and FIG. 5, is not limiting of the invention but can be applied to solar electric modules having layered constructs as shown in other figures elsewhere herein (see FIGS. 2, 3, 6, 7 or 9), including layered constructs that have different layers or layers in a different order than is shown in FIGS. 4 and 5. In one embodiment, the second light transmitting layer 42 of encapsulant is placed next to the solar cells 36; as a result, during the lamination process, the solar cells 36 are encapsulated by the encapsulating sheet 54 ( part of the first light transmitting layer 34) and by the encapsulating material of the second layer 42 (see for example FIG. 3). The manufacturing process, as described for FIGS. 4 and 5, is not limiting of the invention and can also be applied to solar electric modules having different electrical conductors between solar cells 36 than the tabbing 38 indicated in FIG. 5.

FIG. 6 is a schematic representation of a cross section of components 52, 54, 82 and 84 of a first transparent layer 34 according to the principles of the invention. The first transparent layer 34 includes the weight mitigation layer 52 and the encapsulating sheet 54. In various embodiments, the weight mitigation layer 52 includes one or more plastic sheets of polymer, ionomer, or both. In one embodiment, the weight mitigation layer 52 includes EVA layers designed generally by reference numeral 82 and one or more ionomer layers designated generally by reference numeral 84 (shown as one ionomer layer 84 in FIG. 6). The ionomer layer 84 has the advantage of providing heightened protection from UV rays than would be otherwise provided if only having EVA layers, because the ionomer material provides UV blocking properties. Thus, the inclusion of an ionomer layer 84 provides additional protection against UV-caused degradation that can occur in the EVA layers (for example, 82 and 54) that have the ionomer layer 84 between them and the light source (sun). Thus the use of an ionomer layer 84 provides the unexpected and fruitful result of also providing additional U-V protection.

In the embodiment shown in FIG. 6, one ionomer layer 84 is shown sandwiched (or intermediate) between two EVA layers 82. Thus a layered construct for the weight mitigation layer 52 is formed that includes one or more EVA layers 82, then one or more ionomer layers 84, and then one ore more EVA layers 82. In various embodiments, the weight mitigation layered construct of ionomer and EVA layers is not limited by the invention to what is shown in FIG. 6, and other layered constructs can be used. For example, the layers can be one or more EVA layers 82, one or more ionomer layers 84, one or more EVA layers 82, one or more ionomer layers 84, and one or more EVA layers 82.

The EVA layers 82 and the ionomer layer 84 are bonded together by the lamination process. In other embodiments, the layers 82 and 84 are bonded together by various processes such as an adhesive approach or other suitable process.

In another embodiment, the weight mitigation layer 52 includes an ionomer layer 84 having 2 sheets of ionomer and 2 sheets of EVA 82, each sheet of ionomer having a thickness of about one millimeter, and each sheet of EVA 82 having a thickness of about one-half millimeter. The ionomer layer 84 (including two sheets of ionomer) is bonded between the two sheets of EVA 82.

In one embodiment, the weight mitigation layer 52 includes a sheet of ionomer 84 having a thickness of about one millimeter, and two sheets of EVA 82, each sheet of EVA having a thickness of about one-half millimeter. The sheet of ionomer 84 is bonded between the two sheets of EVA 82.

FIG. 7 is an exploded schematic representation of a cross section of a solar cell module including a composite backskin 60 in accordance with the principles of the invention. The composite backskin 60 is formed from a backskin 44 that is contoured (for example with V-shaped grooves or another pattern) and coated with a reflective coating 48. The approach of the invention shown in FIG. 7 provides a simplified module construction in which the reflector material (for example, reflective coating 48) and backskin 44 form a single sheet of material. In one embodiment, the backskin 44 is formed from a polymer material imprinted with a pattern. In one embodiment, the pattern includes grooves (for example V-shaped grooves) or pyramids of predetermined dimensions. In one embodiment, the composite backskin 60 includes a substrate or support 46 with the reflective coating 48 disposed on a back surface 47 of the support 46 facing the backskin 44. The support 46, reflective coating 48, and backskin 44 are bonded together to form the composite backskin 60.

In an alternate embodiment, the backskin material 44 or support 46 can have an embedded light reflecting pattern produced by predetermined variations in refractive index. In such an approach the composite backskin 60 provides a diffractive or holographic pattern that causes incident light to be diffracted upwards toward the transparent front panel 28 where the diffracted light is reflected back by the front surface 30 toward the upper surfaces 57 of the solar cells 36. In a composite backskin 60 which includes a reflector material (for example reflective coating 48), the manufacturing steps and robotic equipment required can be reduced to simplify manufacturing procedures and lower production costs. In one embodiment, the assembly process for a laminated solar electric module (for example as shown in FIG. 5), requires fewer layers to assemble, because the two layers (reflective coating 48 and backskin 44) or three layers (substrate or support 46 with reflective coating 48 on a back facing surface of 46, and backskin 44) are combined into one layer for the composite backskin 60 and received at the module assembly facility or factory as one sheet of material.

In one embodiment, the approach of the invention is used with a composite backskin 60 according to U.S. Published Patent Application US 2004/0123895 to Kardauskas and Piwczyk.

According to another aspect of the invention, the reflecting sheet or layer 40 and/or backskin composite 60 including the reflective coating 48 are fabricated to allow various degrees of moisture (that is, water) penetration. FIG. 8 is an plan (overhead) view of a solar cell module 62 including moisture permeability areas 66, according to the principles of the invention. In the overhead view shown in FIG. 8, the moisture permeability areas 66 are areas underneath the solar cells 36. In one embodiment, the moisture permeability areas 66 are windows (for example, openings or apertures) in the moisture control reflector layer 64 that are the same size as the moisture permeability areas 66 or are a smaller size. In one embodiment, each window is less than the area of the solar cell 36. In another embodiment, each window is about 90 per cent of the area of the solar cell 36. In other embodiments, the moisture permeability areas 66 include one or more windows that are smaller in size than the moisture permeability areas 66 shown in FIG. 8. In one embodiment, the moisture control reflector layer 64 is a reflecting layer 40 that includes moisture control features, as shown in and discussed for FIG. 8 and FIG. 9. FIG. 9 is a schematic representation of a cross section of a laminated solar cell module including a moisture mitigation feature in accordance with the principles of the invention. The solar cell module of FIG. 9 shows a reflecting layer 40 that is a metallic layer or includes a metallic layer 48 that is impervious to the migration of moisture. The reflecting layer 40 has perforations designated generally by the reference numeral 70. The perforations 70 allow for the travel of moisture that accumulates in the encapsulant volume 68, which, in one embodiment, includes EVA. In one embodiment, the encapsulant volume 68 includes the first light transmitting layer 34 and the second light transmitting layer 42. If the permeability is too high, then corrosion may occur within the solar module because there is too much moisture; and if the permeability is too low, then corrosion may occur because acetic acid, moisture, and other corrosive molecules cannot migrate out of the module.

To achieve the desired penetration, reflector metal films used in the reflector layer 40 (or composite backskin 60) are generated with a moisture permeability area 66 or perforations 70 to increase moisture transport adjacent to the back of each solar cell 36 as required by the encapsulant properties. In one embodiment, the moisture permeability area 66 includes perforations 70 in the reflector layer 40 (or composite backskin 60).

Small molecules (such as acetic acid, water, and/or other corrosive molecules) designated generally by the reference numeral 72 can migrate into or out of the encapsulant volume 68 are, shown in FIG. 9. A small molecule 72A located in the encapsulant volume 68, migrates on a sample path 74, through a perforation 70 to a location for the molecule 72B outside of the solar electric module. The small molecule 72B is the same molecule as 72A after following the sample path 74 from the location of molecule 72A to the location indicated by 72B. The encapsulant volume 68 is an encapsulating material (for example, polymer) that allows moisture related molecules to migrate throughout the encapsulant volume 68. The backskin 44 is a moisture permeable material that also allows moisture migration. The reflecting layer 40 is resistant or impervious to moisture migration. The reflecting layer 40 and/or the metallic reflective coating 48 include perforations 70 (or windows) to allow moisture migration.. If the reflecting layer 40 has a layer or coating of an electrically insulating material, then the insulating material is typically also impervious or resistant to moisture and also has perforations 70 to allow moisture migration..

In one embodiment, the moisture control feature of the invention is used with conventional reflector metal films such as those described in Kardauskas.

By example, module design and materials are selected depending on their water retention index, moisture permeability and the susceptibility of the materials interior to the module to produce byproducts through the action of UV radiation and temperature excursions, which then may subsequently combine with water to degrade module properties. Water vapor also affects the integrity of the bond between various sheet materials in a module (for example, layers 34, 40, 42 and 44) and the strength of the interface bonding to glass (for example, bonding of the first transparent layer 34 to a glass transparent front panel 28). The most common encapsulating material, EVA, is typically used under conditions where some water molecule transport through the backskin sheet 44 is permitted. Advantageously, moisture is not trapped, and the moisture and known byproducts of EVA decomposition, such as acetic acid, are allowed to diffuse to prolong module material life; for example, by discouraging EVA discoloration.

In various embodiments of the invention, the backskin 44 material includes a breathable polyvinyl fluoride polymer or other polymer to form the moisture permeable material, including polymer materials and layered polymer combinations suitable for use with the invention, as well as those to be developed in the future. A typical moisture permeability index or transmissivity which is typical of breathable backskin material and which is achieved through perforation of the reflective metal film 48 on the reflecting backskin 44 is about one gram through about ten grams per square meter per day. It is to be understood that the approach of the invention can also be used for small molecule migration through a backskin that is permeable to such small molecules.

EVA is typically used with a TPT backskin 44, which defines one class of breathable materials. TPT is a layered material of TEDLAR®, polyester, and TEDLAR®. TEDLAR® is the trade name for a polyvinyl fluoride polymer made by E.I. Dupont de Nemeurs Co. In one embodiment, the TPT backskin 44 has a thickness in the range of about 0.006 inch to about 0.010 inch.

In another embodiment, the backskin 44 is composed of TPE, which is a layered material of TEDLAR®, polyester, and EVA, which is also a "breathable" moisture permeable material.

Typical metal reflector films 48 have a low moisture permeability index. While this may have advantages with encapsulants used in double glass constructions, the lack of moisture permeability is not desirable with a material such as EVA where module lifetime is adversely affected. More specifically, low moisture permeability such as that present with a metallic reflective coating 48 increases the possibility that the moisture byproducts of EVA decomposition will be trapped inside the module. Trapped moisture can increase corrosion of solar cell metallization and moisture transport in and out of the interior of the module may be inhibited to a degree sufficient to significantly degrade module performance with time and shorten the useable lifetime of the module.

According to the invention, the reflecting layer 40, or the composite structure 60, including the reflective coating 48, are perforated to modify the moisture permeability in the regions behind the solar cells 36 (see the moisture permeability areas 66 in FIG. 8). In one embodiment, only the reflective coating 48 is perforated. In another embodiment, any insulating layer or coating associated with the reflecting layer 40 or backskin composite 60 is also perforated. The perforated regions 66 correspond to regions obscured or "shadowed" by the solar cells 36 that do not contribute to reflecting light. For example the perforations 70 can include hundreds of holes of the order of one through ten microns in diameter drilled by a laser. In other embodiments, other methods of perforation are used, such as mechanical (hole puncturing) methods. Alternatively, entire sections or "windows" of metalized film layer which are of the order of the solar cell area from behind the solar cells 36 can be created. (for example, see the moisture permeability areas 66 of FIG. 8).

In one embodiment, the solar cells 36, as shown in the array of solar cells 36 in FIG. 8, are rectangular in shape, with dimensions of about 62.5 millimeters and about 125 millimeters, which are fabricated by cutting square solar cells of 125 millimeters per side in half. In another embodiment, the solar cells 36 have dimensions of about 52 millimeters and about 156 millimeters, which are fabricated by cutting square solar cells 36 of 156 millimeters per side in thirds. The solar cells are spaced about 15 to 30 millimeters apart.

The perforations 70 range in size from one perforation per solar cell 36 (one window per solar cell 36) to numerous small perforations 70 (one micron in diameter or larger). In one embodiment, the moisture control feature of the invention is in a range of about 10 to about 1000 perforations per square centimeter. In various embodiments, perforations 70 can extend into areas between the solar cells 36. In various embodiments, the perforations 70 can vary in size, and in one embodiment can range from about one micron to about 10 microns in diameter for different embodiments. In various embodiments the total area of the perforations 70 ranges from about 0.1 to 1 per cent of the total surface area of the reflecting layer 40 (but a larger percentage if a large perforation or windows approach is used, or more moisture permeability is required). In various embodiments, the amount of perforations 70 varies according to the moisture permeability of the backskin 44. In various embodiments, the perforations 70 have various dimensions or shapes (for example, circular, oval, square, rectangular, or other shapes).

In one embodiment, a scrim layer is included in the module, disposed adjacent to the back surface of the solar cell (for example, back surface 59 of the solar cell 36). The scrim layer is a porous layer that assists in the movement of gas bubbles during the module lamination process to help remove the bubbles from the encapsulant. In one embodiment, the scrim layer is a fiberglass material of about 0.010 inch in thickness, or other suitable porous material.

Having described the preferred embodiments of the invention, it will now become apparent to one of skill in the arts that other embodiments incorporating the concepts may be used. It is felt, therefore, that these embodiments should not be limited to the disclosed embodiments but rather should be limited only by the scope of the following claims.

## Claims

1. A solar electric module comprising:
a transparent front cover (28) having a front surface and a back surface;
a plurality of solar cells (36) configured in a substantially coplanar arrangement and
spaced apart from each other;
a back cover (50) spaced apart from and substantially parallel to said transparent front cover, said plurality of solar cells disposed between said transparent front cover and said back cover said solar cells having front surfaces (57) facing said transparent front cover and back surfaces (59) facing away from said transparent front cover, each solar cell having one front surface and one back surface;
a light transmitting encapsulant (34) disposed between said transparent front cover and said back cover; and
a reflecting layer (40) disposed between said solar cells and said back cover, said transparent front cover transmitting light through said transparent front cover and incident on said reflecting layer in regions between said solar cells, said reflecting layer directing said light towards said transparent front cover, and said front surface of said transparent front cover internally reflecting said light back towards said front surfaces of said solar cells; **characterised in that**
said reflecting layer has a plurality of perforations (70) of a predetermined size at least in regions obscured by said solar cells, said perforations providing moisture transport into and out from said light transmitting encapsulant.

2. The solar electric module of claim 1, wherein said back cover comprises a backskin layer (60) having a front surface facing the transparent front cover.

3. The solar electric module of claim 2, wherein said backskin layer has a permeability index from about one to about ten grams per square meter per day.

4. The solar electric module of claim 2, wherein said backskin layer comprises a polyvinyl fluoride polymer.

5. The solar electric module of claim 2, wherein said backskin layer and said reflecting layer are fabricated from a single sheet to form a composite backskin.

6. The solar electric module of claim 1, wherein said reflecting layer comprises a support layer (40) and a reflective coating disposed on a surface of said support layer facing away from said transparent front cover.

7. The solar electric module of claim 1, wherein said light transmitting encapsulant comprises ethyl vinyl acetate.

8. The solar electric module of claim 1, wherein said perforations form a plurality of windows (66).

9. The solar electric module of claim 8, wherein each window of said plurality of windows is adjacent to each back surface of each solar cell.

10. The solar electric module of claim 1, wherein said reflecting layer is a reflective metal.

11. A solar electric module comprising: a transparent front cover (28) having a front surface and a back surface; a plurality of solar cells (36) configured in a substantially coplanar arrangement and spaced apart from each other; a back cover (50) spaced apart from and substantially parallel to said transparent front cover, said plurality of solar cells disposed between said transparent front cover and said back cover, said solar cells having front surfaces facing said transparent front cover and having back surfaces facing away from said transparent front cover, each solar cell having one front surface and one back surface: a light transmitting layer (34) disposed between said transparent front cover and said back cover and encapsulating said solar cells, said light transmitting layer comprising a first layer (52) of transparent material disposed adjacent to said back surface of said transparent front cover and a second layer (42) of transparent material disposed adjacent to said back surfaces of said solar cells; and a reflecting layer (40) disposed between said solar cells and said back cover, said transparent front cover transmitting light through said transparent front cover and incident on said reflecting layer in regions between said solar cells, said reflecting layer directing said light towards said transparent front cover, and said front surface of said transparent front cover internally reflecting said light back towards said front surfaces of said solar cells; said first layer of transparent material comprising at least one encapsulating sheet adjacent to said front surfaces of said solar cells, and **characterised by** a weight mitigation layer (52) disposed between said back surface of said transparent front cover and said at least one encapsulating sheet; said weight mitigation layer having a density less than said transparent front cover, and replacing a volume of said transparent front cover equal to a volume of said weight mitigation layer.

12. The solar electric module of claim 11, wherein said first layer of transparent material is a thermosetting plastic.

13. The solar electric module of claim 12, wherein said thermosetting plastic comprises ethyl vinyl acetate.

14. The solar electric module of claim 11, wherein said weight mitigation layer comprises ethyl vinyl acetate and an ionomer.

15. The solar electric module of claim 14, wherein said weight mitigation layer comprises at least one sheet of ionomer (84) disposed between two sheets of ethyl vinyl acetate (82).

16. The solar electric module of claim 11, wherein said transparent front cover is a glass sheet having a thickness of approximately one millimeter to about ten millimeters, and said weight mitigation layer has a thickness of approximately about one millimeter to about ten millimeters.

17. The solar electric module of claim 11, wherein said transparent front cover is a glass sheet having a thickness of approximately three millimeters to approximately six millimeters, and said weight mitigation layer has a thickness of approximately two millimeters to approximately six millimeters.

18. The solar electric module of claim 17, wherein said weight mitigation layer comprises two sheets of ionomer and two sheets of ethyl vinyl acetate, each sheet of ionomer having a thickness of about one millimeter, each sheet of ethyl vinyl acetate having a thickness of about one-half millimeter, and said two sheets of ionomer bonded between said two sheets of ethyl vinyl acetate.

19. The solar electric module of claim 17, wherein said weight mitigation layer comprises six sheets of ethyl vinyl acetate, each sheet of ethyl vinyl acetate having a thickness of about one half millimeter.

20. The solar electric module of claim 17, wherein said transparent front cover is a glass sheet having a thickness of approximately five millimeters, and said weight mitigation layer has a thickness of approximately two millimeters.

21. The solar electric module of claim 20, wherein said weight mitigation layer comprises a sheet of ionomer having a thickness of about one millimeter, and two sheets of ethyl vinyl acetate each having a thickness of about one-half millimeter, said sheet of ionomer bonded between said two sheets of ethyl vinyl acetate.

## Patentansprüche

1. Solarstrommodul, das Folgendes umfasst:
eine transparente Frontabdeckung (28) mit einer Vorderseite und einer Rückseite;
mehrere Solarzellen (36), die in einer im Wesentlichen koplanaren Anordnung und voneinander beabstandet konfiguriert sind;
eine Rückabdeckung (50), die von der genannten transparenten Frontabdeckung beabstandet ist und im Wesentlichen parallel dazu verläuft, wobei die genannten mehreren Solarzellen zwischen der genannten transparenten Frontabdeckung und der genannten Rückabdeckung angeordnet sind, wobei die genannten Solarzellen der genannten transparenten Frontabdeckung zugewandte Vorderseiten (57) und von der genannten transparenten vorderen Abdeckung weg zeigende Rückseiten (59) haben, wobei jede Solarzelle eine Vorderseite und eine Rückseite hat;
eine lichtdurchlässige Verkapselung (34), die zwischen der genannten transparenten Frontabdeckung und der genannten Rückabdeckung angeordnet ist; und
eine zwischen den genannten Solarzellen und der genannten Rückabdeckung angeordnete reflektierende Schicht (40), wobei die genannte transparente Frontabdeckung Licht durch die genannte transparente Frontabdeckung lässt, das auf die genannten reflektierenden Schichten in Regionen zwischen den genannten Solarzellen fällt, wobei die genannte reflektierende Schicht das genannte Licht in Richtung auf die genannte transparente Frontabdeckung leitet und wobei die genannte Vorderseite der genannten transparenten Frontabdeckung intern das genannte Licht zurück in Richtung auf die genannten Vorderseiten der genannten Solarzellen reflektiert;
**dadurch gekennzeichnet, dass** die genannte reflektierende Schicht mehrere Perforationen (70) einer vorbestimmten Größe wenigstens in von den genannten Solarzellen verdeckten Regionen hat, wobei die genannten Perforationen einen Feuchtigkeitstransport in die und aus der genannten lichtdurchlässigen Verkapselung ermöglichen.

2. Solarstrommodul nach Anspruch 1, wobei die genannte Rückabdeckung eine hintere Hautschicht (60) mit einer Vorderseite aufweist, die der transparenten vorderen Abdeckung zugewandt ist.

3. Solarstrommodul nach Anspruch 2, wobei die genannte hintere Hautschicht eine Permeabilitätszahl von etwa ein bis etwa zehn Gramm pro Quadratmeter pro Tag hat.

4. Solarstrommodul nach Anspruch 2, wobei die genannte hintere Hautschicht ein Polyvinylfluoridpolymer umfasst.

5. Solarstrommodul nach Anspruch 2, wobei die genannte hintere Hautschicht und die genannte reflektierende Schicht aus einer einzigen Folie gebildet sind, um eine hintere Verbundhaut zu bilden.

6. Solarstrommodul nach Anspruch 1, wobei die genannte reflektierende Schicht eine Trägerschicht (40) und eine Reflexionsbeschichtung umfasst, die auf einer Oberfläche der genannten Trägerschicht von der genannten transparenten Frontabdeckung weg zeigend angeordnet ist.

7. Solarstrommodul nach Anspruch 1, wobei die genannte lichtdurchlässige Verkapselung Ethylvinylacetat umfasst.

8. Solarstrommodul nach Anspruch 1, wobei die genannten Perforationen mehrere Fenster (66) bilden.

9. Solarstrommodul nach Anspruch 8, wobei sich jedes der genannten mehreren Fenster neben jeder Rückseite jeder Solarzelle befindet.

10. Solarstrommodul nach Anspruch 1, wobei die genannte reflektierende Schicht ein reflektierendes Metall ist.

11. Solarstrommodul, das Folgendes umfasst: eine transparente Frontabdeckung (28) mit einer Vorderseite und einer Rückseite; mehrere Solarzellen (36), die in einer im Wesentlichen koplanaren Anordnung und voneinander beabstandet konfiguriert sind; eine Rückabdeckung (50), die von der genannten transparenten Frontabdeckung beabstandet ist und im Wesentlichen parallel dazu verläuft, wobei die genannte mehreren Solarzellen zwischen der genannten transparenten Frontabdeckung und der genannten Rückabdeckung angeordnet sind, wobei die genannten Solarzellen der genannten transparenten Frontabdeckung zugewandte Vorderseiten und von der genannten transparenten Frontabdeckung weg zeigende Rückseiten haben, wobei jede Solarzelle eine Vorderseite und eine Rückseite hat; eine lichtdurchlässige Schicht (36), die zwischen der genannten transparenten Frontabdeckung und der genannten Rückabdeckung angeordnet ist und die genannten Solarzellen verkapselt, wobei die genannte lichtdurchlässige Schicht Folgendes umfasst: eine erste Schicht (52) aus transparentem Material, die neben der genannten Rückseite der genannten transparenten Frontabdeckung angeordnet ist, und eine zweite Schicht (42) aus transparentem Material, die neben den genannten Rückseiten der genannten Solarzellen angeordnet ist; und eine reflektierende Schicht (40), die zwischen den genannten Solarzellen und der genannten Rückabdeckung angeordnet ist, wobei die genannte transparente Frontabdeckung Licht durch die genannte transparente Frontabdeckung lässt, das auf die genannte reflektierende Schicht in Regionen zwischen den genannten Solarzellen fällt, wobei die genannte reflektierende Schicht das genannte Licht in Richtung auf die genannte transparente Frontabdeckung leitet und wobei die genannte Vorderseite der genannten transparenten Frontabdeckung das genannte Licht intern zurück in Richtung auf die genannten Vorderseiten der genannten Solarzellen reflektiert; wobei die genannte erste Schicht aus transparentem Material wenigstens eine Verkapselungsfolie neben den genannten Vorderseiten der genannten Solarzellen umfasst, und **dadurch gekennzeichnet, dass** eine gewichtsmindernde Schicht (52) zwischen der genannten Rückseite der genannten transparenten Frontabdeckung und der genannten wenigstens einen Verkapselungsfolie angeordet ist; wobei die Dichte der genannten gewichtsmindernden Schicht geringer ist als die der transparenten Frontabdeckung und ein Volumen der genannten transparenten Frontabdeckung ersetzt, das gleich einem Volumen der genannten gewichtsmindernden Schicht ist.

12. Solarstrommodul nach Anspruch 11, wobei die genannte erste Schicht aus transparentem Material ein Duroplast ist.

13. Solarstrommodul nach Anspruch 12, wobei der genannte Duroplast Ethylvinylacetat umfasst.

14. Solarstrommodul nach Anspruch 11, wobei die genannte gewichtsmindernde Schicht Ethylvinylacetat und ein Ionomer umfasst.

15. Solarstrommodul nach Anspruch 14, wobei die genannte gewichtsmindernde Schicht wenigstens eine Ionomerfolie (84) umfasst, die zwischen zwei Ethylvinylacetatfolien (82) angeordnet ist.

16. Solarstrommodul nach Anspruch 11, wobei die genannte transparente Frontabdeckung eine Glasplatte mit einer Dicke von etwa einem Millimeter bis etwa zehn Millimeter ist und die genannte gewichtsmindernde Schicht eine Dicke von etwa einem Millimeter bis etwa zehn Millimeter hat.

17. Solarstrommodul nach Anspruch 11, wobei die genannte transparente Frontabdeckung eine Glasplatte mit einer Dicke von etwa drei Millimetern bis etwa sechs Millimeter ist und die genannte gewichtsmindernde Schicht eine Dicke von etwa zwei Millimetern bis etwa sechs Millimeter hat.

18. Solarstrommodul nach Anspruch 17, wobei die genannte gewichtsmindernde Schicht zwei Ionomerfolien und zwei Ethylvinylacetatfolien umfasst, wobei jede Ionomerfolie eine Dicke von etwa einem Millimeter hat, wobei jede Ethylvinylacetatfolie eine Dicke von etwa einem halben Millimeter hat und die genannten zwei Ionomerfolien zwischen die genannten Ethylvinylacetatfolien geklebt sind.

19. Solarstrommodul nach Anspruch 17, wobei die genannte gewichtsmindernde Schicht sechs Ethylvinylacetatfolien umfasst, wobei jede Ethylvinylacetatfolie eine Dicke von etwa einem halben Millimeter hat.

20. Solarstrommodul nach Anspruch 17, wobei die genannte transparente Frontabdeckung eine Glasplatte mit einer Dicke von etwa fünf Millimetern ist und die genannte gewichtsmindernde Schicht eine Dicke von etwa zwei Millimetern hat.

21. Solarstrommodul nach Anspruch 20, wobei die genannte gewichtsmindernde Schicht eine Ionomerfolie mit einer Dicke von etwa einem Millimeter hat und zwei Ethylvinylacetatfolien jeweils eine Dicke von etwa einem halben Millimeter haben, wobei die genannte Ionomerfolie zwischen die genannten zwei Ethylvinylacetatfolien geklebt ist.

## Revendications

1. Module électrique solaire comprenant :
un couvercle frontal transparent (28) ayant une surface avant et une surface arrière ;
une pluralité de piles solaires (36) configurées en un agencement sensiblement coplanaire et espacées les unes des autres ;
un couvercle arrière (50) espacé dudit couvercle frontal transparent et sensiblement parallèle à celui-ci, ladite pluralité de piles solaires étant disposée entre ledit couvercle frontal transparent et ledit couvercle arrière, lesdites piles solaires ayant des surfaces avant (57) faisant face audit couvercle frontal transparent et des surfaces arrière (59) opposées audit couvercle frontal transparent, chaque pile solaire ayant une surface avant et une surface arrière ;
un encapsulant transmettant la lumière (34) disposé entre ledit couvercle frontal transparent et ledit couvercle arrière ; et
une couche réfléchissante (40) disposée entre lesdites piles solaires et ledit couvercle arrière, ledit couvercle frontal transparent transmettant la lumière qui passe à travers lui et qui frappe ladite couche réfléchissante dans des régions entre lesdites piles solaires, ladite couche réfléchissante dirigeant ladite lumière vers ledit couvercle frontal transparent, et ladite surface avant dudit couvercle frontal transparent réfléchissant intérieurement ladite lumière de retour vers lesdites surfaces avant desdites piles solaires; **caractérisé en ce que**
ladite couche réfléchissante a une pluralité de perforations (70) d'une dimension prédéterminée au moins dans des régions obscurcies par lesdites piles solaires, lesdites perforations assurant le transport d'humidité dans ledit encapsulant transmettant la lumière et hors de celui-ci.

2. Module électrique solaire selon la revendication 1, dans lequel ledit couvercle arrière comprend une couche de film de revers (60) ayant une surface avant faisant face au couvercle frontal transparent.

3. Module électrique solaire selon la revendication 2, dans lequel ladite couche de film de revers a un indice de perméabilité d'environ un à environ dix grammes par mètre carré par jour.

4. Module électrique solaire selon la revendication 2, dans lequel ladite couche de film de revers comprend un polymère de polyfluorure de vinyle.

5. Module électrique solaire selon la revendication 2, dans lequel ladite couche de film de revers et ladite couche réfléchissante sont fabriquées à partir d'une même feuille afin de former un film de revers composite.

6. Module électrique solaire selon la revendication 1, dans lequel ladite couche réfléchissante comprend une couche de support (40) et un revêtement réfléchissant disposé sur une surface de ladite couche de support opposée audit couvercle frontal transparent.

7. Module électrique solaire selon la revendication 1, dans lequel ledit encapsulant transmettant la lumière comprend de l'éthyl-vinyl acétate.

8. Module électrique solaire selon la revendication 1, dans lequel lesdites perforations forment une pluralité de fenêtres (66).

9. Module électrique solaire selon la revendication 8, dans lequel chaque fenêtre de ladite pluralité de fenêtres est adjacente à chaque surface arrière de chaque pile solaire.

10. Module électrique solaire selon la revendication 1, dans lequel ladite couche réfléchissante est un métal réflecteur.

11. Module électrique solaire comprenant : un couvercle frontal transparent (28) ayant une surface avant et une surface arrière ; une pluralité de piles solaires (36) configurées en un agencement sensiblement coplanaire et espacées les unes des autres ; un couvercle arrière (50) espacé dudit couvercle frontal transparent et sensiblement parallèle à celui-ci, ladite pluralité de piles solaires étant disposée entre ledit couvercle frontal transparent et ledit couvercle arrière, lesdites piles solaires ayant des surfaces avant faisant face audit couvercle frontal transparent et des surfaces arrière opposées audit couvercle frontal transparent, chaque pile solaire ayant une surface avant et une surface arrière ; une couche transmettant la lumière (34) disposée entre ledit couvercle frontal transparent et ledit couvercle arrière et encapsulant lesdites piles solaires, ladite couche transmettant la lumière comprenant une première couche (52) de matière transparente disposée à proximité de ladite surface arrière dudit couvercle frontal transparent et une seconde couche (42) de matière transparente disposée à proximité desdites surfaces arrière desdites piles solaires ; et une couche réfléchissante (40) disposée entre lesdites piles solaires et ledit couvercle arrière, ledit couvercle frontal transparent transmettant la lumière qui passe à travers lui et qui frappe ladite couche réfléchissante dans des régions entre lesdites piles solaires, ladite couche réfléchissante dirigeant ladite lumière vers ledit couvercle frontal transparent, et ladite surface avant dudit couvercle frontal transparent réfléchissant intérieurement ladite lumière de retour vers lesdites surfaces avant desdites piles solaires ; ladite première couche de matière transparente comprenant au moins une feuille encapsulante adjacente auxdites surfaces avant desdites piles solaires, et **caractérisé par** une couche de réduction de poids (52) disposée entre ladite surface arrière dudit couvercle frontal transparent et ladite au moins une feuille encapsulante ; ladite couche de réduction de poids ayant une densité inférieure à celle dudit couvercle frontal transparent, et remplaçant un volume dudit couvercle frontal transparent égal à un volume de ladite couche de réduction de poids.

12. Module électrique solaire selon la revendication 11, dans lequel ladite première couche de matière transparente est un plastique thermodurcissable.

13. Module électrique solaire selon la revendication 12, dans lequel ledit plastique thermodurcissable comprend de l'éthyl-vinyl acétate.

14. Module électrique solaire selon la revendication 11, dans lequel ladite couche de réduction de poids comprend de l'éthyl-vinyl acétate et un ionomère.

15. Module électrique solaire selon la revendication 14, dans lequel ladite couche de réduction de poids comprend au moins une feuille d'ionomère (84) disposée entre deux feuilles d'éthyl-vinyl acétate (12).

16. Module électrique solaire selon la revendication 11, dans lequel ledit couvercle frontal transparent est une feuille de verre d'une épaisseur d'environ un millimètre à environ dix millimètres, et ladite couche de réduction de poids a une épaisseur d'environ un millimètre à environ dix millimètres.

17. Module électrique solaire selon la revendication 11, dans lequel ledit couvercle frontal transparent est une feuille de verre d'une épaisseur d'environ trois millimètres à environ six millimètres, et ladite couche de réduction de poids a une épaisseur d'environ deux millimètres à environ six millimètres.

18. Module électrique solaire selon la revendication 11, dans lequel ladite couche de réduction de poids comprend deux feuilles d'ionomère et deux feuilles d'éthyl-vinyl acétate, chaque feuille d'ionomère ayant une épaisseur d'environ un millimètre, chaque feuille d'éthyl-vinyl acétate ayant une épaisseur d'environ un demi millimètre, et lesdites deux feuilles d'ionomère étant collées entre lesdites deux feuilles d'éthyl-vinyl acétate.

19. Module électrique solaire selon la revendication 17, dans lequel ladite couche de réduction de poids comprend six feuilles d'éthyl-vinyl acétate, chaque feuille d'éthyl-vinyl acétate ayant une épaisseur d'environ un demi millimètre.

20. Module électrique solaire selon la revendication 17, dans lequel ledit couvercle frontal transparent est une feuille de verre d'une épaisseur d'environ cinq millimètres, et ladite couche de réduction de poids a une épaisseur d'environ deux millimètres.

21. Module électrique solaire selon la revendication 20, dans lequel ladite couche de réduction de poids comprend une feuille d'ionomère ayant une épaisseur d'environ un millimètre, et deux feuilles d'éthyl-vinyl acétate ayant chacune une épaisseur d'environ un demi millimètre, ladite feuille d'ionomère étant collée entre lesdites deux feuilles d'éthyl-vinyl acétate.
